(19) Europäisches Patentamt
European Patent Office
Office européen des brevets

(11) EP 2 840 620 A1

(12) DEMANDE DE BREVET EUROPEEN

(43) Date de publication:
25.02.2015 Bulletin 2015/09

(51) Int Cl.:
*H01L 33/38* (2010.01)

(21) Numéro de dépôt: 14181581.1

(22) Date de dépôt: 20.08.2014

(84) Etats contractants désignés:
AL AT BE BG CH CY CZ DE DK EE ES FI FR GB
GR HR HU IE IS IT LI LT LU LV MC MK MT NL NO
PL PT RO RS SE SI SK SM TR
Etats d'extension désignés:
BA ME

(30) Priorité: 23.08.2013 FR 1358146

(71) Demandeur: COMMISSARIAT A L'ENERGIE
ATOMIQUE ET AUX
ENERGIES ALTERNATIVES
75015 Paris (FR)

(72) Inventeur: Vaufrey, David
38000 Grenoble (FR)

(74) Mandataire: Novaimo
Bâtiment Europa 2
310 avenue Marie Curie
Archamps Technopole
74166 Saint Julien en Genevois Cedex (FR)

(54) **Procédé d'élaboration d'une électrode pour diode électroluminescente utilisant la longueur de dispersion du courant dans ladite diode**

(57) Procédé d'élaboration d'une électrode (101) pour diode électroluminescente (100) comportant:

ladite électrode sur une face (105) de son empilement (103) et une surface émissive définie par les zones de la face (105) non recouvertes par l'électrode (101); cette électrode étant conformée de sorte que tout point de la surface émissive est situé, au plus, à une distance prédéterminée de ladite électrode, dépendante de la longueur de dispersion du courant, et comportant une pluralité de branches (101a-d) parallèles, avec distance en-tre branches comprise entre 2/3 de la longueur de dispersion et cette longueur +200μm;

procédé comportant:

- étape de détermination de la longueur de dispersion dans la diode devant être équipée par ladite électrode,

- étape de détermination d'au moins une caractéristique de ladite électrode à partir de la longueur de dispersion déterminée.

FIG.2

**Description**

Domaine technique de l'invention

L'invention concerne le domaine des diodes électroluminescentes, et plus particulièrement un agencement de l'électrode formée sur une face émissive d'un empilement de la diode électroluminescente.

L'invention a pour objet plus particulièrement un procédé d'élaboration d'une première électrode d'injection de porteurs pour une diode électroluminescente, ce procédé prenant en compte une longueur de dispersion déterminée de ladite diode..

État de la technique

Une diode électroluminescente est généralement composée d'un empilement d'au moins deux matériaux semi-conducteurs de type de conductivité opposée et inséré entre deux électrodes. Lorsqu'une tension est appliquée entre les deux électrodes, des porteurs sont injectés via lesdites électrodes dans l'empilement de semi-conducteurs, puis sont transportés dans les semi-conducteurs. Des électrons sont injectés depuis la cathode, alors que des trous sont injectés depuis l'anode. Des paires électron-trou peuvent se former dans une zone active de l'empilement, et peuvent aboutir à des excitons, qui peuvent se désexciter de manière radiative. Les photons générés peuvent s'échapper de l'empilement de semi-conducteurs si, à minima, l'une des électrodes est transparente ou semi-transparente, ou si l'une des électrodes ne recouvre pas complètement une face émissive d'un empilement la diode électroluminescente, ou encore si une combinaison des deux possibilités évoquées ci-avant est utilisée.

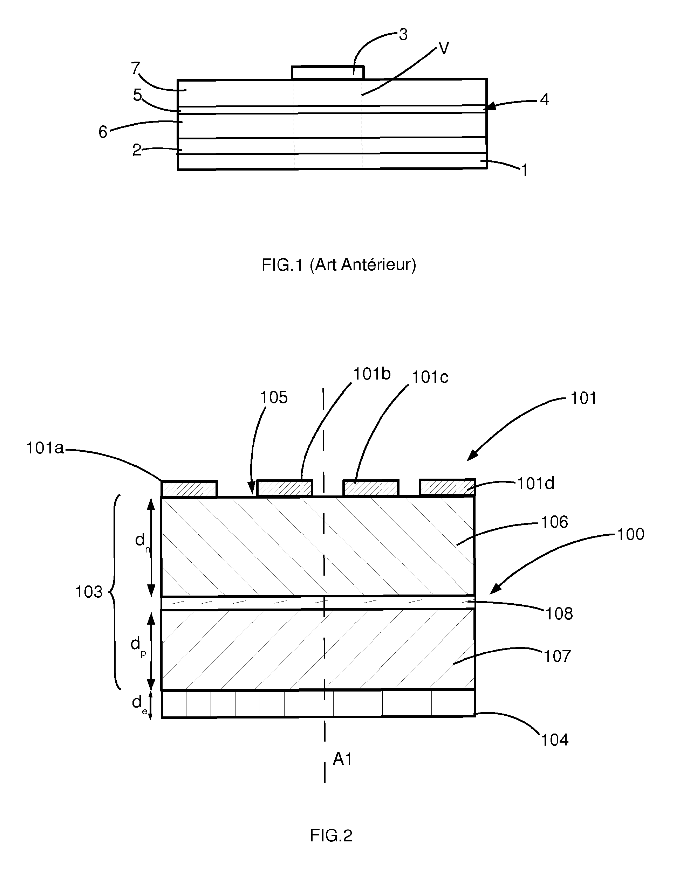

La figure 1 illustre un exemple en vue latérale d'une diode électroluminescente dans une configuration à couche mince (configuration aussi connue sous l'acronyme VTF pour « Vertical Thin Film » en langue anglaise). Une électrode 1 recouvre intégralement la face arrière d'un substrat 2 semi-conducteur. Une autre électrode 3 ne recouvre que partiellement la face supérieure d'un empilement 4 de semi-conducteurs formé en face supérieure du substrat 2. On peut aussi considérer que l'empilement 4 comporte le substrat 2. L'empilement 4 de semi-conducteurs comporte une couche active 5 insérée entre deux couches de transport 6, 7 de type de conductivité opposée. De part, la structuration des électrodes 1 et 3, les lignes de courants se concentrent dans l'empilement 4 de semi-conducteurs dans un volume minimisant la distance entre les deux électrodes 1 et 3. Autrement dit, le courant se concentre principalement dans la couche active 5 au niveau du volume V de la couche active 5 ombré par l'électrode 3 ne recouvrant que partiellement la face supérieure de l'empilement 4 de semi-conducteurs. Ainsi, la densité de courant est maximale et constante dans le volume V de la couche active 5 ombré par l'électrode 3 ne recouvrant que partiellement la face supérieure de l'empilement 4 de semi-conducteurs.

La luminance d'une diode électroluminescente étant proportionnelle à la densité de courant traversant la diode électroluminescente au niveau de la couche active 5, la distribution de luminance décroit donc rapidement plus on se décale latéralement de la zone située sous l'électrode 3. Si l'électrode 3 est non transparente, seuls les photons émis dans la zone périphérique au volume V de la région d'émission peuvent s'échapper de la diode électroluminescente.

Pour s'affranchir de cette limitation, les documents de l'art antérieur enseignent plusieurs stratégies.

L'une de ces stratégies consiste à introduire une couche de propagation (« spreading layer » en langue anglaise) entre l'électrode 3 et la couche active 5. La couche de propagation se caractérise par une conductivité élevée. Lorsque la diode électroluminescente est pourvue d'une couche de propagation, le courant diverge plus largement et la région d'émission couvre une surface plus importante.

Une autre stratégie consiste à utiliser une structuration planaire de l'électrode 3 permettant une distribution plus homogène du courant dans l'empilement de semi-conducteurs.Cependant, bien que l'art antérieur enseigne des formes de distribution de l'électrode sur la face émissive de la diode électroluminescente, il ne suggère pas de règle précise. De plus, il ne précise pas non plus comment optimiser le flux émis par la diode électroluminescente.

**Objet de l'invention**

Le but de la présente invention est de proposer une solution qui remédie aux inconvénients listés ci-dessus.

On tend vers ce but par les revendications annexées et notamment grâce à un procédé d'élaboration d'une première électrode d'injection de porteurs pour une diode électroluminescente comportant : la première électrode destinée à injecter des porteurs d'un premier type dans un empilement de la diode électroluminescente et agencée sur une face émissive de l'empilement, une deuxième électrode destinée à injecter des porteurs d'un deuxième type dans l'empilement, et une surface émissive délimitée par des zones de la face émissive de l'empilement non recouvertes par la première électrode, la première électrode étant conformée de telle sorte que tout point de la surface émissive est situé au plus à une distance prédéterminée de la première électrode dépendante de la longueur de dispersion de la diode électroluminescente, et la première électrode comportant une pluralité de branches sensiblement parallèles entre elles, la distance séparant deux branches adjacentes étant comprise entre 2/3 de la longueur de dispersion et 1 fois la longueur de dispersion plus 200μm, ledit procédé comportant une étape de détermination de la longueur de dispersion de la diode électroluminescente destinée à être équipée par la première électrode, et une étape de détermination d'au moins une caractéristique, notamment la forme, de la première électrode à partir de la longueur de dispersion déterminée.

La longueur de dispersion peut être calculée à partir de caractéristiques de l'empilement et de la deuxième électrode.

Si la longueur de dispersion est inférieure ou égale à 60μm, la distance séparant deux branches adjacentes de la première électrode (101) est avantageusement comprise entre 2 fois la longueur de dispersion et 2,5 fois la longueur de dispersion plus 50μm.

Si la longueur de dispersion est supérieure ou égale à 30μm, la distance séparant deux branches adjacentes de la première électrode est avantageusement comprise entre 2/3 fois la longueur de dispersion plus 50μm et 2/3 fois la longueur de dispersion plus 200μm.

Notamment, la largeur de chaque branche de la pluralité de branches de la première électrode est inférieure à 10μm, et de préférence inférieure ou égale à 5μm.

Selon une réalisation, la première électrode comporte deux tronçons additionnels reliant toutes les extrémités longitudinales des branches de la pluralité de branches et formant, avec deux branches distales de la pluralité de branches, une piste fermée entourant toutes les autres branches de la pluralité de branches.

Selon un perfectionnement, la face émissive de l'empilement comporte un bord périphérique éloigné de la première électrode d'une distance comprise entre ¼ et ½ de la longueur de dispersion.

L'invention est aussi relative à un procédé de fabrication d'une diode électroluminescente, ledit procédé de fabrication comportant :

- une étape de mise en oeuvre du procédé d'élaboration de la première électrode tel que décrit,
- une étape de formation de la première électrode sur la face émissive de l'empilement de la diode électroluminescente.

**Description sommaire des dessins**

D'autres avantages et caractéristiques ressortiront plus clairement de la description qui va suivre de modes particuliers de réalisation de l'invention donnés à titre d'exemples non limitatifs et représentés sur les dessins annexés, dans lesquels :

- la figure 1 est une vue latérale d'une réalisation selon l'état de la technique,
- la figure 2 illustre une vue en coupe latérale d'une réalisation selon un mode d'exécution de l'invention,
- la figure 3 illustre l'influence de nombre de branches d'une électrode en fonction du flux total émis par une diode électroluminescente, de la distance entre les branches de l'électrode, et de la longueur de dispersion du courant dans la diode électroluminescente,
- la figure 4 illustre une vue en perspective d'un mode d'exécution selon l'invention,
- les figures 5 et 6 illustrent comment sont choisies respectivement deux gammes de distances entre deux branches d'une électrode à partir d'une courbe donnant l'évolution de la distance optimale entre deux branches d'une même électrode en fonction de la longueur de dispersion,
- la figure 7 illustre l'efficacité relative en fonction de la densité de courant renvoyée pour une diode en GaInN à une longueur d'onde de 440nm sur une zone de 1 mm$^2$ à une température de 300K.

**Description de modes préférentiels de l'invention**

La présente invention s'intéresse plus particulièrement au lien entre la longueur de dispersion du courant dans la diode électroluminescente et les formes adoptées par l'électrode de la diode électroluminescente située à l'interface d'une face émissive d'un empilement de la diode électroluminescente.

Dans la présente description, la longueur de dispersion de la diode électroluminescente fait référence à la longueur de dispersion du courant de la diode électroluminescente.

Comme illustré à la figure 2, la diode électroluminescente 100 comporte une première électrode 101 destinée à injecter des porteurs d'un premier type dans un empilement 103 de la diode électroluminescente 100. Cette première électrode 101 est agencée sur une face émissive 105 de l'empilement 103. La diode électroluminescente 100 comporte aussi une deuxième électrode 104 destinée à injecter des porteurs d'un deuxième type dans l'empilement 103. Une surface émissive de la diode électroluminescente est délimitée par des zones de la face émissive 105 de l'empilement 103 non recouvertes par la première électrode 101. Sur l'exemple non limitatif de la figure 2, la première électrode 101 comporte une pluralité de branches 101 a, 101b, 101c, 101 d préférentiellement sensiblement parallèles.

Dans la présente description, par sensiblement parallèle, on entend exactement parallèle ou parallèle à plus ou moins 5 degrés en fonction des contraintes de fabrication desdites branches de la première électrode 101.

Dans la présente description, par sensiblement perpendiculaire, on entend exactement perpendiculaire ou perpendiculaire à plus ou moins 5 degrés.

L'empilement 103 peut comporter un premier élément semi-conducteur 106 notamment dopé n dans lequel la première électrode 101 injecte des porteurs et un deuxième élément semi-conducteur 107 notamment dopé p dans lequel la deuxième électrode 104 injecte des porteurs. De manière plus générale, l'empilement 103 d'une diode électroluminescente est aussi appelé dans le domaine un empilement de semi-conducteurs. Les premier et deuxième éléments semi-conducteurs 106 et 107, se présentant par exemple chacun sous la forme d'une couche, peuvent être séparés l'un de l'autre par une couche active 108 comprenant par exemple des puits quantiques favorisant la recombinaison des porteurs injectés par les première et deuxième électrodes 101, 104.

Plus particulièrement, les première et deuxième électrodes sont disposées de part et d'autre de l'empilement. Ainsi, comme visible aux figures au moins une partie de la deuxième électrode peut être en vis-à-vis de la première électrode, formant ainsi un ombrage entre les première et deuxième électrodes.

Selon un exemple particulier de réalisation, le premier élément semi-conducteur 106 est une couche en nitrure de Gallium (GaN) dopé N, de préférence de résistivité $1^e$-3 Ohm.cm, et le deuxième élément semi-conducteur 107 est une couche en nitrure de Gallium (GaN) dopé P, de préférence de résistivité 1 Ohm.cm. Dans ce cas, la première électrode 101 est la cathode disposée sur la face externe de la couche dopée N qui présente notamment la résistivité la plus faible.

Ainsi, on comprend que la première électrode 101 correspond avantageusement à l'électrode adjacente à la couche de conductivité la plus élevée (de résistivité la plus faible)

La surface émissive d'une diode est définie par la face de la diode électroluminescente par laquelle sont émis la majorité des photons.

En particulier, la face émissive 105 est préférentiellement, selon la direction dans laquelle l'empilement 103 est réalisé, une première face d'extrémité de l'empilement 103. On peut alors considérer que cette première face d'extrémité est incluse dans un plan perpendiculaire à la direction d'empilement (axe A1 de la figure 2). Cette première face de l'empilement 103 est opposée à une deuxième face de l'empilement 103 disposée préférentiellement à l'interface avec la deuxième électrode 104. Autrement dit, entre les première et deuxième électrodes 101, 104 s'étendent les différentes couches formant l'empilement 103 échelonnées selon la direction d'empilement. De préférence, la deuxième face d'extrémité de l'empilement 103 est totalement recouverte par la deuxième électrode 104. L'empilement 103 peut aussi comporter un substrat ayant permis de former le reste de l'empilement, ce substrat est alors électriquement conducteur pour permettre l'injection de charges au travers dudit substrat.

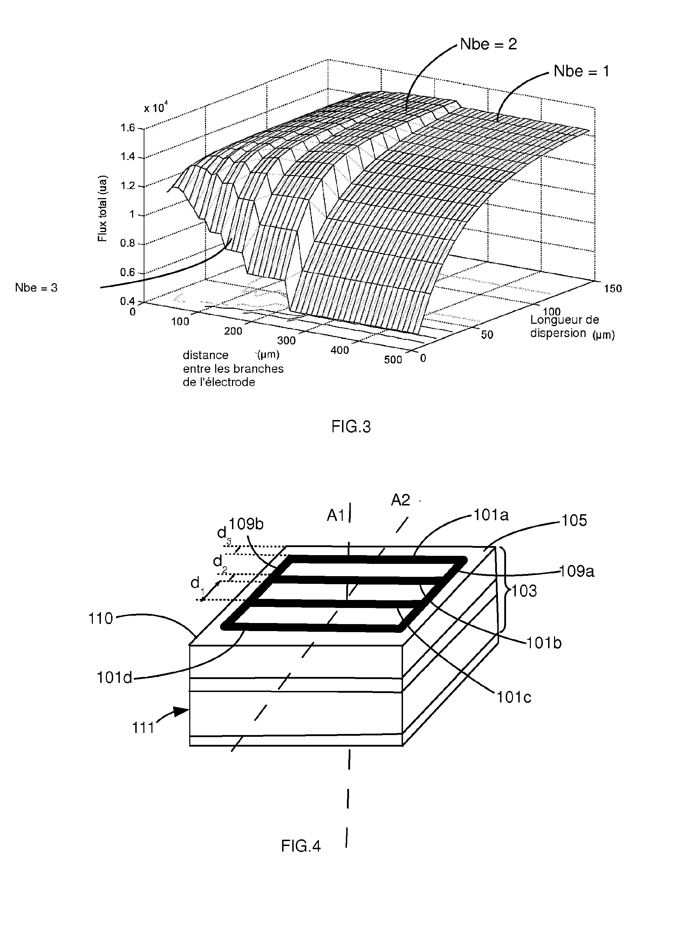

Dans le cadre du développement de l'invention, il a été mis en avant de manière surprenante que la multiplication de branches de l'électrode, bien que générant des zones d'ombrage supplémentaires au niveau de la face d'émission 105 de l'empilement 103 de la diode électroluminescente 100, pouvait être bénéfique du fait d'un meilleur rendement des zones non ombrées. En ce sens, la figure 3 illustre schématiquement le flux total émis par une diode électroluminescente mesuré en fonction de la distance séparant deux branches adjacentes d'une électrode (autrement dit, en fonction du nombre de branches Nbe d'une électrode disposée sur la face émissive 105 de l'empilement) présente sur la face émissive de l'empilement 103 la diode électroluminescente 100 et en fonction de la longueur de dispersion du courant dans la diode électroluminescente. Sur la figure 3, à chaque marche de la surface tracée correspond une incrémentation d'une unité de Nbe.

Il apparait de l'analyse de la figure 3 qu'en utilisant une seule électrode ponctuelle (Nbe=1), il est impératif d'accroitre la longueur de dispersion du courant dans la diode électroluminescente pour atteindre des flux optiques importants, et que, de manière plus surprenante, il faut multiplier le nombre de branches de l'électrode, au détriment de la surface émissive pour atteindre des flux optiques importants si la diode électroluminescente n'affiche pas une longueur de dispersion suffisante. On notera que les flux optiques obtenus avec un nombre optimal de branches de la première électrode 101 permettent d'atteindre des valeurs de flux du même ordre voir légèrement supérieur au flux émis par une diode électroluminescente ne disposant que d'une seule branche d'électrode et présentant une grande longueur de dispersion. Par exemple, pour une diode électroluminescente de 1x1mm, on a Flux(Longueur dispersion=150$\mu$m, distance inter électrode=500$\mu$m) ~ Flux(Longueur dispersion=50$\mu$m, distance inter électrode=80$\mu$m pour Nbe=6).

On comprend alors que l'augmentation de l'efficacité de la diode électroluminescente mise en avant par l'augmentation du nombre de branches de la première électrode dépend en fait de la distance séparant tout point de la surface émissive de la première électrode 101. Autrement dit, de manière plus générale, la première électrode 101 est conformée de telle sorte que tout point de la surface émissive est situé au plus à une distance prédéterminée de la première électrode 101 dépendante de la longueur de dispersion de la diode électroluminescente 100.

En fait, la longueur de dispersion (en langue anglaise : spreading length) correspond à la distance pour laquelle la densité courant a chuté d'un rapport 1/e entre un premier point contenu dans la plan de la couche active et périphérique au volume V (volume ombré par la première électrode) et un second point contenu dans le même plan. Autrement dit, la longueur de dispersion du courant peut correspondre à la distance entre un premier point défini par l'intersection du plan de la couche active avec la hauteur en un point périphérique de l'électrode 101 par rapport au plan de l'électrode 104, et un deuxième point situé dans le plan de la couche active pour lequel le rapport entre la densité de courant en ce deuxième point divisé par la densité de courant au premier point est égale à 1/e.

A titre d'exemple, la longueur de dispersion Ls d'une diode électroluminescente selon la figure 2 peut être calculée de la manière suivante :

$$Ls = \sqrt{\left(\sum \rho_c + \sum \rho_\perp . d_\perp\right). \left|\frac{\rho_n}{d_n} - \frac{\rho_e}{d_e}\right|^{-1}} \quad \text{équation (1)}$$

Avec $\rho_n$, $\rho_e$, $\rho_p$ les résistivités respectives du premier élément semi-conducteur 106 dopé n, de la deuxième électrode 104 et du deuxième élément semi-conducteur 107 dopé p (notamment utilisées dans les sommes $\Sigma\rho_c$ et $\Sigma\rho_\perp.d_\perp$), $d_n$, de, dp les épaisseurs selon la direction de l'empilement (axe A1) respectivement du premier élément semi-conducteur 106 dopé n, de la deuxième électrode 104 et du deuxième élément semi-conducteur 107 dopé p (notamment utilisées dans les sommes $\Sigma\rho_c$ et $\Sigma\rho_\perp.d_\perp$),

$\Sigma\rho_c$ correspondant à la somme des résistances de contact entre les différents matériaux de la diode électroluminescente. Cette valeur peut s'avérer difficile d'accès, aussi la formule peut se simplifier en la négligeant,

$\Sigma\rho_\perp.d_\perp$ correspondant à la somme des produits de la résistivité et de l'épaisseur des différents matériaux traversés par un axe normal A1 au plan de la diode électroluminescente.

Expérimentalement, il est aussi possible de déterminer une longueur de dispersion Ls. Pour ce faire il suffit de polariser entre deux pointes de polarisation la diode électroluminescente pour laquelle on cherche Ls avec une tension non nulle et supérieure à la tension seuil d'électroluminescence de la diode, et de mesurer la décroissance de tension ou de courant en fonction de la distance entre une pointe de mesure se déplaçant sur la surface émissive de la diode et la pointe de polarisation appliquée à l'électrode 101 en contact avec la face émissive 105. La longueur de dispersion correspond alors à la distance à laquelle le courant a chuté d'un facteur 1/e, et/ou à laquelle la tension a chuté de kT/q (soit 25 mV). Cette méthode n'est valable que si les contacts électrode-semi-conducteur sont ohmiques et non Schottky (ce qui est généralement le cas pour des diodes électroluminescentes commercialisées).

Selon la réalisation illustrée à la figure 4, la première électrode 101 comporte une pluralité de branches 101 a, 101b, 101c, 101 d sensiblement parallèles entre elles. De préférence, la distance d1 séparant deux branches adjacentes est comprise entre 2/3 de la longueur de dispersion et 1 fois la longueur de dispersion plus 200μm. Par deux branches adjacentes, on entend que l'électrode ne comporte pas de branche(s) située(s) entre ces deux branches adjacentes. On comprend alors que chaque branche peut comporter deux extrémités longitudinales opposées et que les deux branches adjacentes sont séparées de la distance d1 entre leurs deux extrémités longitudinales opposées. En fait, la présence de ces branches permet de limiter la surface de la face émissive 105 de l'empilement 103 recouverte par la première électrode 101 tout en s'assurant qu'aucun point de la surface émissive n'est pas plus éloigné de la branche la plus proche d'une distance prédéterminée.

Autrement dit, la première électrode peut être conformée de telle sorte que tout point de la surface émissive se situe avantageusement à une distance maximum de la première électrode 101 comprise entre 1/3 de la longueur de dispersion Ls et 1/2 la longueur de dispersion plus 100 μm. Plus généralement, la première électrode peut être conformée de telle sorte que tout point de la surface émissive se situe avantageusement à une distance maximum de la première électrode 101 comprise entre deux fonctions affines dépendantes de la longueur de dispersion.

De préférence, entre leurs extrémités longitudinales opposées, les branches ne sont pas reliées électriquement par d'autres parties de la première électrode 101. Autrement dit, les branches forment une maille unidimensionnelle, à l'opposé d'un maillage bidimensionnel qui formerait un quadrillage, de sorte à limiter le recouvrement de la face émissive par ladite première électrode 101.

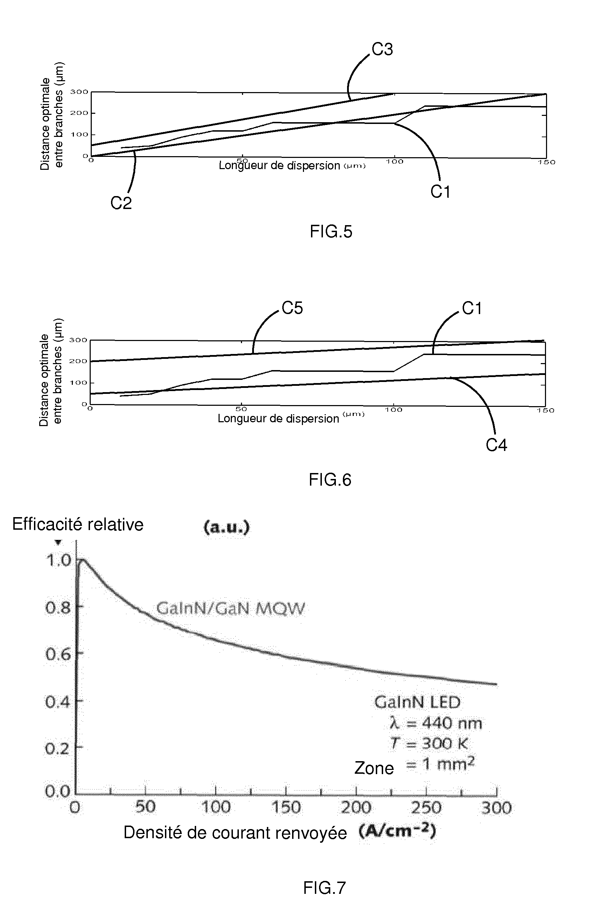

Selon une première mise en oeuvre de la diode électroluminescente, dans le cadre où la longueur de dispersion est inférieure ou égale à 60μm, la distance séparant deux branches adjacentes de la première électrode 101 est comprise entre 2 fois la longueur de dispersion et 2,5 fois la longueur de dispersion plus 50μm. Cette distance de séparation est de préférence comprise entre ces bornes (2 fois la longueur de dispersion et 2,5 fois la longueur de dispersion plus 50μm) entre tout point d'un premier côté latéral d'une première branche adjacent à un deuxième côté latéral d'une deuxième branche, lesdites première et deuxième branches étant bien entendu adjacentes l'une à l'autre. Cette distance s'applique préférentiellement à tous les couples de branches adjacentes de la pluralité de branches de la première électrode 101. En fait, ces conditions sont issues de la figure 5 où la courbe C1 illustre les différentes valeurs optimales de distance entre deux branches adjacentes de l'électrode 101 en fonction de la longueur de dispersion de la diode (c'est-à-dire en fonction de la structure de la diode électroluminescente). Les courbes C2 et C3, sous forme de droites, illustrent des bornes préférées, respectivement associées à 2 fois la longueur de dispersion et 2,5 fois la longueur de dispersion plus 50μm, assurant un bon compromis entre la surface de la face émissive recouverte par la première électrode 101 et l'efficacité de la diode électroluminescente. En fait, les droites C2 et C3 sont avantageusement telles que la longueur de dispersion est inférieure à 60μm, tous les points de la courbe C1 sont compris entre ces deux droites C2, C3.

Selon une deuxième mise en oeuvre de la diode électroluminescente, dans le cadre où la longueur de dispersion est supérieure ou égale à 30μm, la distance séparant deux branches adjacentes de la première électrode 101 est comprise entre 2/3 fois la longueur de dispersion plus 50μm et 2/3 fois la longueur de dispersion plus 200μm. Cette distance de séparation est de préférence comprise entre ces bornes (2/3 fois la longueur de dispersion plus 50μm et 2/3fois la longueur de dispersion plus 200μm) entre tout point d'un premier côté latéral d'une première branche adjacent à un deuxième côté latéral d'une deuxième branche, lesdites première et deuxième branches étant bien entendu adjacentes l'une à l'autre. Cette distance s'applique préférentiellement à tous les couples de branches adjacentes de la pluralité de branches de la première électrode 101. En fait, ces conditions sont issues de la figure 6 où la courbe C1 illustre les différentes valeurs optimales de distance entre deux branches adjacentes de l'électrode 101 en fonction de la longueur de dispersion de la diode (c'est-à-dire en fonction de la structure de la diode électroluminescente).Les courbes C4 et C5, sous forme de droites, illustrent les bornes préférées respectivement associées à 2/3 fois la longueur de dispersion plus 50μm et 2/3 fois la longueur de dispersion plus 200μm.

Dans les première et deuxième mises en oeuvres décrites ci-dessus, en cas de recouvrement de la gamme, on préférera utiliser les bornes associées aux courbes C2 et C3 car la diode électroluminescente obtenue est plus performante.

De préférence, Ls est inférieure à 300μm, ceci vient du fait que généralement, au-delà de 300μm la problématique de dispersion n'est plus présente dans la diode électroluminescente.

De préférence, la largeur d2 de chaque branche 101 a, 101 b, 101c, 101 d de la pluralité de branches de la première électrode est inférieure à 10μm, et de préférence inférieure ou égale à 5μm. En fonction de la technologie utilisée, la largeur minimale d2 peut être d'1μm ou être de l'ordre de 100nm voire moins. En effet, la résistance induite par une telle électrode reste faible, c'est-à-dire inférieure à la résistance induite par la traversée du premier élément semi-conducteur et/ou du deuxième élément semi-conducteur composant la diode électroluminescente. De plus, la résistance de la première électrode 101 peut encore être réduite en accroissant l'épaisseur de l'électrode.

Avantageusement, la première électrode 101 comporte deux tronçons additionnels 109a, 109b reliant, notamment électriquement, toutes les extrémités longitudinales des branches de la pluralité de branches et formant, avec deux branches distales 101 a, 101 d de la pluralité de branches, une piste fermée entourant toutes les autres branches de la pluralité de branches. Par deux branches « distales » on entend les deux branches les plus éloignées l'une de l'autre (les branches de la pluralité de branches étant échelonnées selon l'axe A2 de la figure 4). Autrement dit, chaque branche de la pluralité de branches comporte une première extrémité et une deuxième extrémité, l'un des tronçons additionnels étant sensiblement perpendiculaire aux branches de la pluralité de branches et passant par toutes les premières extrémités et l'autre tronçon additionnel étant sensiblement perpendiculaire aux branches de la pluralité de branches et passant par toutes les deuxièmes extrémités. De préférence, la largeur de ces deux tronçons additionnels 109a, 109b est inférieure à 10μm, et de préférence inférieure ou égale à 5μm, et ce pour les mêmes raisons que la largeur des branches visées ci-dessus.

Toujours selon la figure 4, la face émissive de l'empilement peut comporter un bord périphérique 110 éloigné préférentiellement de la première électrode 101 (en particulier des deux tronçons additionnels 109a, 109b et des deux branches 101 a, 101 d de l'électrode distales l'une de l'autre) d'une distance $d_3$ comprise entre ¼ et ½ de la longueur de dispersion de la diode électroluminescente. Cet éloignement permet de minimiser la surface de la face émissive 105 couverte par la première électrode 101. En fait, le bord périphérique 110 est formé par l'interface entre une première face d'extrémité de l'empilement (formant la face émissive 105) et une paroi latérale 111 de l'empilement reliant la première face d'extrémité de l'empilement à la deuxième face d'extrémité de l'empilement en contact avec la deuxième électrode 104.

L'invention est aussi relative à un procédé d'élaboration d'une première électrode 101 d'injection de porteurs pour une diode électroluminescente telle que décrite précédemment. Un tel procédé d'élaboration peut comporter une étape de détermination de la longueur de dispersion de la diode électroluminescente destinée à être équipée par la première électrode 101. Cette longueur de dispersion peut être déterminée par calcul en utilisant l'équation (1) ci-dessus une fois que la structure de l'empilement souhaité s'étendant de la deuxième électrode est connue, ou être déterminée à partir d'un dispositif étalon comprenant au moins la deuxième électrode souhaitée et un empilement souhaité sur lequel les pointes évoquées précédemment sont utilisées pour déterminer expérimentalement la longueur de dispersion associée. On comprend alors que la longueur de dispersion peut être calculée à partir de caractéristiques de l'empilement souhaité et de la deuxième électrode souhaitée ou bien à partir d'un dispositif expérimental comprenant au moins la deuxième électrode souhaitée et l'empilement souhaité.

Ensuite, le procédé d'élaboration comporte une étape de détermination d'au moins une caractéristique de la première électrode 101 à partir de la longueur de dispersion déterminée. Cette étape de détermination de la première électrode 101 permet par exemple de définir la forme et les dimensions de ladite première électrode 101 à placer sur la face émissive 105 de l'empilement 103.

Par forme de la première électrode, on entend le nombre de branches, la manière dont elles sont reliées, etc.

Cette étape de détermination d'au moins une caractéristique peut être telle que chaque caractéristique déterminée puisse être associée à une limitation particulière de la première électrode. Autrement dit, dans le cadre de l'étape de détermination de ladite au moins une caractéristique, notamment la forme, de la première électrode 101 (élaborée) à partir de la longueur de dispersion déterminée, ladite au moins une caractéristique déterminée peut être telle que :

o la première électrode 101 soit conformée de telle sorte que tout point de la surface émissive est situé au plus à une distance prédéterminée de la première électrode 101 dépendante de la longueur de dispersion déterminée de la diode électroluminescente,

∘ la première électrode 101 comporte une pluralité de branches 101 a, 101b, 101c, 101 d sensiblement parallèles entre elles, notamment la distance d1 séparant deux branches adjacentes étant comprise entre 2/3 de la longueur de dispersion déterminée et 1 fois la longueur de dispersion déterminée plus 200$\mu$m.

Dans le cas ci-dessus, on considère que dans le cadre du procédé, la diode électroluminescente comporte : la première électrode 101 destinée à injecter des porteurs d'un premier type dans un empilement 103 de la diode électroluminescente 100 et agencée sur une face émissive 105 de l'empilement 103 ; une deuxième électrode 104 destinée à injecter des porteurs d'un deuxième type dans l'empilement 103; et une surface émissive délimitée par des zones de la face émissive 105 de l'empilement 103 non recouvertes par la première électrode 101.

De la même manière, l'étape de détermination de ladite au moins une caractéristique, notamment la forme, de la première électrode 101 (élaborée) à partir de la longueur de dispersion déterminée, peut être telle que :

- la longueur de dispersion déterminée étant inférieure ou égale à 60$\mu$m, la distance séparant deux branches adjacentes de la première électrode 101 élaborée est comprise entre 2 fois la longueur de dispersion déterminée et 2,5 fois la longueur de dispersion déterminée plus 50$\mu$m.

- la longueur de dispersion déterminée étant supérieure ou égale à 30$\mu$m, la distance séparant deux branches adjacentes de la première électrode 101 élaborée est comprise entre 2/3 fois la longueur de dispersion déterminée plus 50$\mu$m et 2/3 fois la longueur de dispersion déterminée plus 200$\mu$m.

- la largeur de chaque branche de la pluralité de branches de la première électrode 101 élaborée est inférieure à 10$\mu$m, et de préférence inférieure ou égale à 5$\mu$m.

- la première électrode 101 élaborée comporte deux tronçons additionnels 109a, 109b reliant toutes les extrémités longitudinales des branches de la pluralité de branches et formant, avec deux branches distales de la pluralité de branches, une piste fermée entourant toutes les autres branches de la pluralité de branches.

- la face émissive de l'empilement comportant un bord périphérique 110, ladite la première électrode 101 élaborée adopte une forme telle que tout point de ladite première électrode est situé à une distance minimal dudit bord périphérique comprise entre ¼ et ½ de la longueur de dispersion déterminée.

De manière applicable à tout ce qui a été dit précédemment, le bord périphérique de la face émissive de l'empilement adopte la forme d'une boucle fermée, notamment de forme sensiblement rectangulaire ou carrée, et est éloigné de la première électrode de la distance précisée en tout point.

Bien entendu, l'invention est aussi relative à un procédé de fabrication d'une diode électroluminescente telle que décrite, un tel procédé de fabrication comporte une étape de mise en oeuvre du procédé d'élaboration de la première électrode décrit ci-dessus, et une étape de formation de la première électrode 101 sur la face émissive 105 de l'empilement 103 de la diode électroluminescente. Le procédé de fabrication peut en outre comporter toutes les étapes technologiques pour former les différentes parties de la diode électroluminescente telle que décrite précédemment.

De manière générale, l'obtention dans une diode électroluminescente d'une densité de courant la plus uniforme possible n'implique pas la meilleure efficacité de la diode (Figure 7). Ceci est notamment dû à l'effet « droop ». L'effet « droop » est relié au fait que l'efficacité lumineuse d'une diode atteint un pic à des densités de courant faible avant de diminuer alors que la densité de courant augmente. L'effet « droop » apparait typiquement au moment où la densité de courant atteint quelque dizaines d'ampères par centimètre carré. Dans le cadre de la présente invention, on cherche notamment à maximiser l'efficacité de la diode lorsque Ls est faible. L'agencement particulier de la première électrode de la diode telle que définie ci-avant permet de contrer cet effet « droop », on obtient donc une meilleur efficacité de la diode.

**Revendications**

1. Procédé d'élaboration d'une première électrode (101) d'injection de porteurs pour une diode électroluminescente (100) comportant: la première électrode (101) destinée à injecter des porteurs d'un premier type dans un empilement (103) de la diode électroluminescente (100) et agencée sur une face émissive (105) de l'empilement (103), une deuxième électrode (104) destinée à injecter des porteurs d'un deuxième type dans l'empilement (103), et une surface émissive délimitée par des zones de la face émissive (105) de l'empilement (103) non recouvertes par la première électrode (101), la première électrode (101) étant conformée de telle sorte que tout point de la surface émissive est situé au plus à une distance prédéterminée de la première électrode (101) dépendante de la longueur de dispersion de la diode électroluminescente, et la première électrode (101) comportant une pluralité de branches (101 a, 101b, 101c, 101 d) sensiblement parallèles entre elles, la distance (d1) séparant deux branches adjacentes étant comprise entre 2/3 de la longueur de dispersion et 1 fois la longueur de dispersion plus 200$\mu$m, ledit procédé comportant une étape de détermination de la longueur de dispersion de la diode électroluminescente (100) destinée à être équipée par la première électrode (101), et une étape de détermination d'au moins une caractéristique, notamment la forme, de la première électrode (101) à partir de la longueur de dispersion déterminée.

2. Procédé selon la revendication précédente, **caractérisé en ce que** la longueur de dispersion est calculée à partir de caractéristiques de l'empilement (103) et de la deuxième électrode (104).

3. Procédé selon l'une des revendications précédentes, **caractérisé en ce que** la longueur de dispersion étant inférieure ou égale à 60$\mu$m, la distance séparant deux branches adjacentes de la première électrode (101) est comprise entre 2 fois la longueur de dispersion et 2,5 fois la longueur de dispersion plus 50$\mu$m.

4. Procédé selon l'une des revendications 1 ou 2, **caractérisé en ce que** la longueur de dispersion étant supérieure ou égale à 30$\mu$m, la distance séparant deux branches adjacentes de la première électrode (101) est comprise entre 2/3 fois la longueur de dispersion plus 50$\mu$m et 2/3 fois la longueur de dispersion plus 200$\mu$m.

5. Procédé selon l'une des revendications 1 à 4, **caractérisé en ce que** la largeur de chaque branche de la pluralité de branches de la première électrode (101) est inférieure à 10$\mu$m, et de préférence inférieure ou égale à 5$\mu$m.

6. Procédé l'une des revendications 1 à 5, **caractérisée en ce que** la première électrode (101) comporte deux tronçons additionnels (109a, 109b) reliant toutes les extrémités longitudinales des branches de la pluralité de branches et formant, avec deux branches distales de la pluralité de branches, une piste fermée entourant toutes les autres branches de la pluralité de branches.

7. Procédé selon l'une des revendications 1 à 6, **caractérisé en ce que** la face émissive de l'empilement comporte un bord périphérique (110) éloigné de la première électrode (101) d'une distance comprise entre ¼ et ½ de la longueur de dispersion.

8. Procédé de fabrication d'une diode électroluminescente (100), **caractérisé en ce qu'**il comporte :

   - une étape de mise en oeuvre du procédé d'élaboration de la première électrode (101) selon l'une des revendications 1 ou 7,
   - une étape de formation de la première électrode (101) sur la face émissive (105) de l'empilement (103) de la diode électroluminescente.

FIG.1 (Art Antérieur)

FIG.2

FIG.3

FIG.4

FIG.5

FIG.6

FIG.7

**Europäisches Patentamt**
**European Patent Office**
**Office européen des brevets**

# RAPPORT DE RECHERCHE EUROPEENNE

Numéro de la demande

EP 14 18 1581

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/023239 A1 (ERCHAK ALEXEI A [US] ET AL) 22 janvier 2009 (2009-01-22) <br> * alinéas [0250] - [0264]; figures 78A-C * <br> * alinéas [0246] - [0249]; figures 77A,B * <br> ----- | 1-8 | INV. <br> H01L33/38 |
| A | US 2012/146047 A1 (KNEISSL MICHAEL [DE] ET AL) 14 juin 2012 (2012-06-14) <br> * alinéas [0017], [0030] - [0033]; figure 1 * <br> * alinéas [0035] - [0040]; figures 3-5 * <br> ----- | 1-8 | |
| A | GUO X ET AL: "Current crowding in GaN/InGaN light emitting diodes on insulating substrates", JOURNAL OF APPLIED PHYSICS, AMERICAN INSTITUTE OF PHYSICS, 2 HUNTINGTON QUADRANGLE, MELVILLE, NY 11747, vol. 90, no. 8, 15 octobre 2001 (2001-10-15), pages 4191-4195, XP012054351, ISSN: 0021-8979, DOI: 10.1063/1.1403665 <br> * abrégé * <br> * Equation 9; page 4191, colonne 2, ligne 1 - page 4195, colonne 1, ligne 11; figures 1a-b, 6, 7a-c * <br> * page 4195, alinéa Conclusions * <br> ----- | 1-5,8 | |
| A | KIM HYUNSOO ET AL: "Measurements of current spreading length and design of GaN-based light emitting diodes", APPLIED PHYSICS LETTERS, AMERICAN INSTITUTE OF PHYSICS, US, vol. 90, no. 6, 8 février 2007 (2007-02-08), pages 63510-063510, XP012095990, ISSN: 0003-6951, DOI: 10.1063/1.2450670 <br> * le document en entier * <br> ----- | 1,6-8 | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| La Haye | 8 janvier 2015 | Tinjod, Frank |

**ANNEXE AU RAPPORT DE RECHERCHE EUROPEENNE
RELATIF A LA DEMANDE DE BREVET EUROPEEN NO.**

EP 14 18 1581

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-01-2015

| Document brevet cité au rapport de recherche | Date de publication | Membre(s) de la famille de brevet(s) | Date de publication |
|---|---|---|---|
| US 2009023239 A1 | 22-01-2009 | AUCUN | |
| US 2012146047 A1 | 14-06-2012 | DE 102009034359 A1 | 17-02-2011 |
| | | EP 2454762 A1 | 23-05-2012 |
| | | JP 2012533874 A | 27-12-2012 |
| | | KR 20120054006 A | 29-05-2012 |
| | | US 2012146047 A1 | 14-06-2012 |
| | | WO 2011006995 A1 | 20-01-2011 |

EPO FORM P0460

Pour tout renseignement concernant cette annexe : voir Journal Officiel de l'Office européen des brevets, No.12/82